# EUROPÄISCHE PATENTSCHRIFT

(11) **EP 0 909 122 B1**
(45) Veröffentlichungstag und Bekanntmachung des Hinweises auf die Patenterteilung: **12.03.2003**
(21) Anmeldenummer: 98118897.2
(22) Anmeldetag: 07.10.1998
(51) Int. Cl.: H05K 7/14, H02B 1/052

(54) **Elektronisches Gerät**
Electrical assembly
Appareil électrique

(30) Priorität: 09.10.1997 DE 19744662
(43) Veröffentlichungstag der Anmeldung: 14.04.1999
(73) Patentinhaber: Phoenix Contact GmbH & Co. KG, 32825 Blomberg (DE)
(72) Erfinder: Beilfuss-Spickmann, Uwe, Dipl.-Ing., 31787 Hameln (DE); Follmann, Hartmut, Dipl.-Ing., 32699 Extertal (DE); Quardt, Dirk, Dipl.-Ing., 32816 Schieder-Schwalenberg (DE)
(74) Vertreter: Gesthuysen, von Rohr & Eggert

(56) Entgegenhaltungen:
- EP-A- 0 236 711
- DE-A- 3 316 389
- DE-A- 3 819 669

## Beschreibung

Die Erfindung betrifft ein Elektronisches Gerät zum Aufsetzen auf eine Tragschiene , mit einem Gehäuse, wobei das Gehäuse aus einem mit der Tragschiene lösbar verbindbaren Gehäuseunterteil und aus einem mit dem Gehäuseunterteil lösbar verbindbaren Gehäuseoberteil besteht, das Gehäuseunterteil zum einen eine Elektronik enthält und zum anderen die Verbindung zu einem Bus-System herstellt und das Gehäuseoberteil über Steckerkontakte mit dem Gehäuseunterteil verbunden ist.

Die Verwendung eines Bus-Systems bei der Installation einer Anlage, die aus verschiedenen Maschinen, Sensoren und Aktoren besteht, ermöglicht eine rationelle Art der Verbindung der gesamten Anlage, so daß früher übliche armdicke und kilometerlange Kabelstränge, die bei der Parallelverdrahtung entstanden, entfallen können. Hierbei spielen Ein-/Ausgabemodule eine entscheidende Rolle, da sie die Anschlußmöglichkeiten der einzelnen Bus-Teilnehmer an die Bus-Leitung und damit an die Steuerung liefern, so daß Signale von der Steuerung zu den Bus-Teilnehmern und umgekehrt übertragen werden können. Die Elektronik eines Ein-/Ausgabemodule verbindet die durch parallele Verdrahtung an das Ein-/Ausgabemodul angeschlosse-nen Bus-Teilnehmer mit der seriellen Bus-Leitung. Eine solche Bus-Leitung kann z. B. eine einfache Zweidrahtleitung oder auch ein Lichtwellenleiterkabel sein.

Das eingangs beschriebene elektronische Gerät kann beispielsweise ein solches Ein/Ausgabemodul darstellen, ohne daß die Erfindung jedoch auf ein solches beschränkt ist. Durch die Verwendung von Bus-Systemen ist eine einfache und übersichtliche Verbindung einzelner Maschinen sowie einzelner Sensoren und Aktoren untereinander und mit der Steuerung möglich, so daß der Aufwand bei der Montage und Inbetriebnahme verringert werden kann. Soll eine bestehende Anlage jedoch erweitert oder verändert werden bzw. müssen defekte elektronische Geräte ausgetauscht wer-den, so ist dies immer noch mit einem relativ großen Arbeitsaufwand verbunden.

Aus der EP 0 236 711 A2 ist ein eingangs beschriebenes elektronisches Gerät bekannt, wobei es sich bei den bekannten Gerät um ein Automatisierungsgerät handelt, das eine Reihe von Baugruppenträgern, die auf die Tragschiene aufschnappbar sind, dazugehörige Ein- bzw. Ausgabebaugruppen und zusätzliche Anschlußblöcke aufweist. Die Ein- und Ausgabegruppen sind auf die Baugruppenträger aufsteckbar und verrastbar. Die Befestigung der Baugruppenträger erfolgt derart, daß diese über Vorsprünge an der Tragschiene eingehängt und nach Verschwenken mittels eines federbelasteten Riegels an der Tragschiene verrastet werden.

Der vorliegenden Erfindung liegt somit die Aufgabe zugrunde, das eingangs beschriebene elektronische Gerät dahingehend zu verbessern, daß Montage-, Inbetriebnahme- und Reparaturarbeiten einfacher durchgeführt werden können und die Elektronik oder die Anschüsse des Gerätes leicht zu verändern sind, so daß eine bestehende Anlage neuen, veränderten Anforderungen einfacher angepaßt werden kann.

Diese Aufgabe ist erfindungsgemäß zunächst dadurch gelöst, daß das Gehäuseoberteil Anschlüsse fiir elektrische Leitungen aufweist, die Anschlüsse über die Steckerkontakte mit dem Gehäuseunterteil verbunden sind, das Gehäuseoberteil über eine rastbare Verriegelung mit dem Gehäuseunterteil verbindbar ist, wobei die Verriegelung wenigstens einen federnden Rastarm und einen zum Rastarm korrespondierenden Rasthaken aufweist und der Rastarm am Gehäuseoberteil und der Rasthaken am Gehäuseunterteil vorgesehen sind.

Durch diese Ausgestaltung ist zum einen eine einfacher Anschluß der elektrischen Leitungen an das Gerät möglich, da die Anschlüsse am Gehäuseoberteil leicht zugänglich sind: Zum anderen ist eine einfache, aber dennoch sichere Befestigung des Gehäuseoberteils auf dem Gehäuseunterteil gewährleistet. Das Gehäuseoberteil kann von dem Gehäuseunterteil durch eine einfache manuelle Betätigung gelöst werden, ohne daß hierzu ein Werkzeug erforderlich ist. Durch diese Art der Modultechnik kann eine Anpassung des elektronischen Gerätes an veränderte Anforderungen und eine Reparatur der Elektronik durch einfaches Austauschen des Gehäuseoberteils und/oder des Gehäuseunterteils erfolgen.

Besonders vorteilhaft ist es, wenn mehrere Geräte benachbart zueinander auf der Tragschiene aufrastbar und über selbstaufbauende Stromschienen miteinander kontaktierbar sind. Hierdurch ist ein hochmodularer Stationsaufbau möglich, so daß durch Aufrasten einzelner elektronischer Geräte auf die Tragschiene, ohne ein Werk-zeug zu benötigen, kleine - für die Versorgung einer einzelnen Maschine ausreichen-de - Schaltkästen realisiert werden können.

Besonders vorteilhaft ist es, wenn eine Mehrzahl von elektronischen Geräten, die benachbart auf einer Tragschiene befestigt sind, derart ausgebildet ist, daß jedes beliebige Gerät, unabhängig von seiner Position innerhalb der Mehrzahl von elektronischen Geräten, ausgetauscht werden kann. Hierdurch muß beim Austausch eines defekten Geräts, welches sich in einer mittigen Position befindet, nur dieses gelöst werden und nicht eine größere Anzahl weiterer Geräte, was der Fall wäre, wenn die Geräte lediglich seitlich auf die Tragschiene aufgeschoben werden könnten.

Weiter vorteilhaft ist es, wenn das Gehäuseunterteil seinerseits zwei federnde Rastarme aufweist, über die die an der Unterseite des Gehäuseunterteils angeordneten Rasthaken betätigt werden können, mit Hilfe derer das Gehäuseunterteil auf der Tragschiene lösbar befestigt ist. Hierdurch ist zusätzlich eine einfache, aber dennoch sichere Befestigung des Gehäuseunterteils auf der Tragschiene gewährleistet. Somit kann, je nach Bedarf, entweder das Gehäuseoberteil gänzlich von dem Gehäuseunterteil abgenommen werden, oder es wird lediglich an einer Seite gelöst und über die schwenkbare Verbindung mit dem Gehäuseunterteil hochgeklappt.

Nach einer weiteren Ausgestaltung der Erfindung, die hier noch erwähnt werden soll, übernimmt einer der beiden Rastarme des Gehäuseunterteils gleichzeitig die Funktion des Rasthakens für den korrespondierenden Rastarm des Gehäuseoberteils. Hierdurch ist eine einfachere Herstellung des Gehäuses insgesamt, insbesondere jedoch des Gehäuseunterteils möglich. Durch die doppelte Funktion des einen Rastarms des Gehäuseunterteils kann eine relativ schmale Ausführung des gesamten Gehäuses erreicht werden, wodurch die Modularität des elektronischen Gerätes weiter verbessert wird.

Die selbstaufbauende Stromschiene, mit deren Hilfe auf der Tragschiene benachbart aufgerastete elektronische Gerät kontaktiert werden, besteht vorzugsweise aus einem auf der einen Seite des Gehäuseunterteils überstehenden Messerkontakt und einer auf der anderen Seite überstehenden doppelschenkligen Kontaktaufnahme für diesen Messerkontakt. Die Verwendung einer solchen selbstaufbauenden Stromschiene macht ein manuelles Verdrahten der einzelnen elektronischen Geräte überflüssig, gewährleistet aber dennoch einen sicheren Kontakt zwischen den einzelnen Geräten, so daß sowohl der Datentransfer als auch die Stromübertragung durch die Geräte stattfinden kann.

Eine weitere Ausgestaltung der Erfindung, die sich dann als besonders vorteilhaft erweist, wenn eine Mehrzahl von elektronischen Geräten benachbart auf einer Tragschiene aufgerastet sind, ist dadurch gekennzeichnet, daß beim Lösen des Gehäuseunterteils des n-ten Gerätes das Gehäuseoberteil des (n+1)-ten Gerätes automatisch zumindest einseitig gelöst wird. Dadurch wird auf besonders einfache, aber dennoch wirkungsvolle Weise sichergestellt, daß dann, wenn ein Gehäuseunterteil von der Tragschiene gelöst wird, dieses Gehäuseunterteil nicht ein benachbartes Gehäuseoberteil mit seinen seitlich überstehenden Messerkontakten durch das Herausziehen beschädigt.

Eine letzte Besonderheit einer vorteilhaften Ausgestaltung der Erfindung, auf die hier noch einmal besonders eingegangen werden soll, besteht darin, daß am oberen Rand des Gehäuseunterteils ein zusätzliches Gehäuseelement schwenkbar angelenkt ist und dieses Gehäuseelement zur Aufnahme einer Sicherung dient. Dieses Gehäuseelement - wie das gesamte Gehäuseunterteil - wird im Betriebszustand des elektronischen Gerätes durch das Gehäuseoberteil abgedeckt, es ist dann in das Innere des Gehäuseunterteils eingeschwenkt. Ist jedoch die Sicherung defekt, so kann auf einfache Weise das Gehäuseoberteil gelöst bzw. aufgeschwenkt werden und dann das Gehäuseelement mit der defekten Sicherung aus dem Gehäuseunterteil herausgeschwenkt werden. Dies ist ohne ein spezielles Werkzeug möglich, so daß der Benutzer das Austauschen einer Sicherung innerhalb weniger Augenblicke erledigen kann.

Im einzelnen gibt es nun eine Vielzahl von Möglichkeiten, das erfindungsgemäße elektronische Gerät auszugestalten. Dazu wird verwiesen einerseits auf die dem Patentanspruch 1 nachgeordneten Patentansprüche, andererseits auf die Beschreibung bevorzugter Ausführungsbeispiele in Verbindung mit der Zeichnung. In der Zeichnung zeigen
- Fig. 1: eine dreiteilige Prinzipdarstellung des Lösungsmechanismus des erfindungsgemäßen elektronischen Gerätes,
- Fig. 2: eine Mehrzahl von benachbart auf einer Tragschiene aufgerasteten elektronischen Geräten,
- Fig. 3: eine Prinzipdarstellung einer selbstaufbauenden Stromschiene eines erfindungsgemäßen Gerätes,
- Fig. 4: einen Detailausschnitt zweier benachbarter erfindungsgemäßer Geräte,
- Fig. 5: eine Ausführungsform eines Gehäuseunterteils eines erfindungsgemäßen Gerätes,
- Fig. 6: das Gehäuseunterteil entsprechend Fig. 5 mit einem ausgeschwenkten Gehäuseelement zur Aufnahme einer Sicherung,
- Fig. 7: eine Ausführungsform eines Gehäuseoberteils und eines Gehäuseunterteils eines erfindungsgemäßen Gerätes, wobei bei dem Gehäuseunterteil eine Seitenwand fehlt,
- Fig. 8: eine Prinzipdarstellung der möglichen Steckerkodierung eines erfindungsgemäßen Gerätes,
- Fig. 9: eine Ausführungsform eines erfindungsgemäßen Gerätes mit Feldern zur Signalkennzeichnung,
- Fig. 10: mehrere unterschiedliche Varianten eines Gehäuseoberteils eines erfindungsgemäßen Gerätes und
- Fig. 11: eine komplette Ein-/Ausgabebox mit mehreren erfindungsgemäßen elektronischen Geräten.

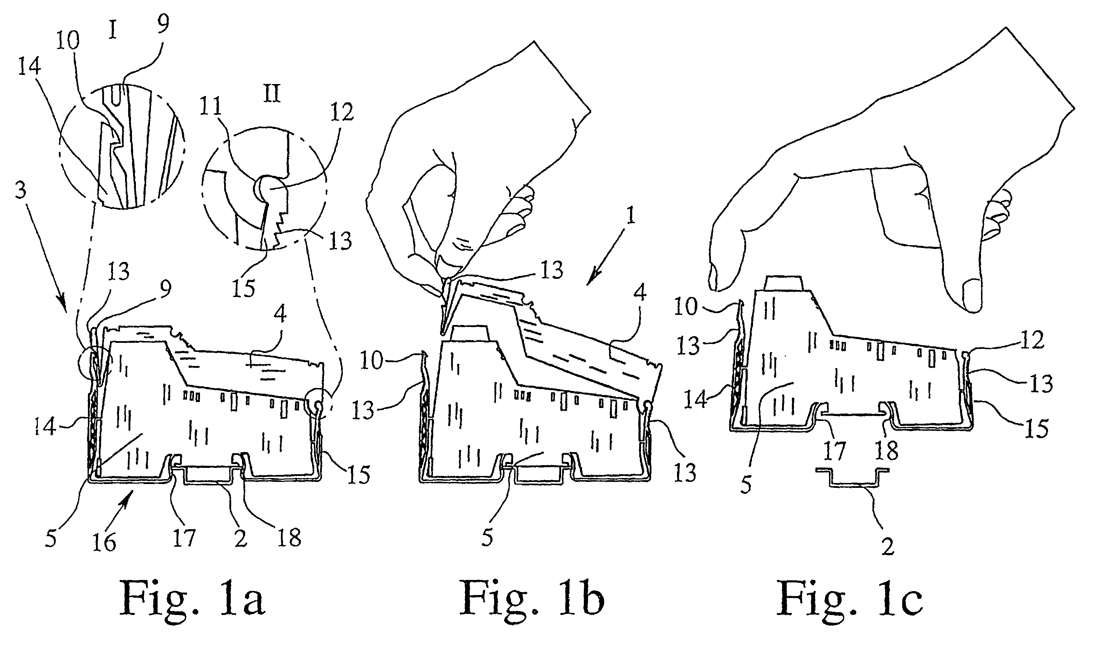

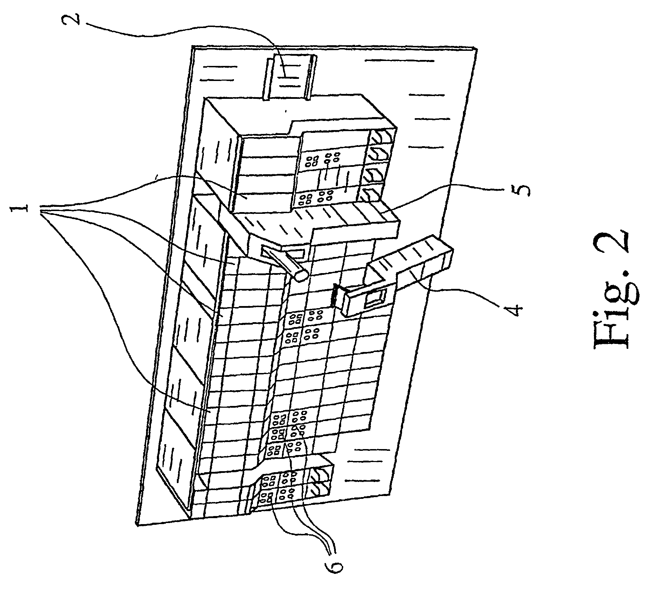

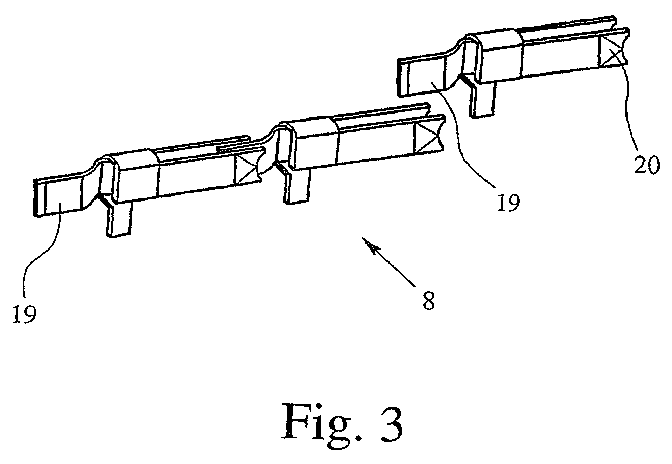

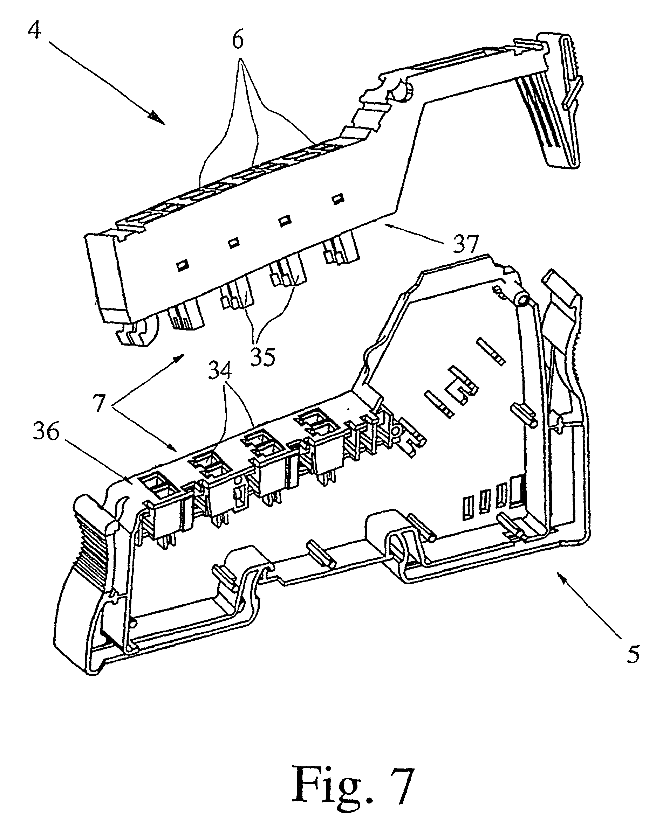

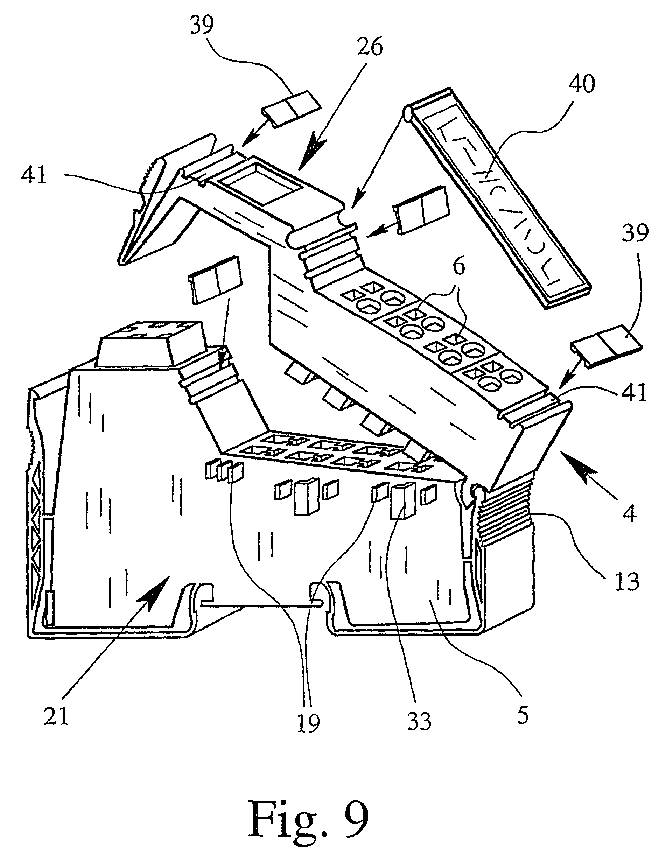

Fig. 1 zeigt in drei Schritten (Fig. 1 a - 1 c) das Lösen eines erfindungsgemäßen elektronischen Gerätes 1 von einer hutförmigen Tragschiene 2. Das elektronische Gerät 1 weist ein Gehäuse 3 auf, welches aus einem Gehäuseoberteil 4 und einem Gehäuseunterteil 5 besteht. Das Gehäuseoberteil 4 weist Anschlüsse 6 für elektrische Leitungen auf, die mit dem Gehäuseunterteil 5 über Steckerkontakte 7 verbunden sind (siehe Fig. 7 und Fig. 9). Fig. 2 zeigt eine Mehrzahl von benachbart auf einer Tragschiene 2 aufgerasteten elektronischen Geräten 1, wobei die elektronischen Geräte 1 mittels selbstaufbauender Stromschienen 8 miteinander kontaktiert sind. Eine solche Stromschiene 8 ist im Detail in Fig. 3 dargestellt.

In Fig. 1, insbesondere in den zu Fig. 1 a gehörenden Detailvergrößerungen I und II ist eine rastbare Verriegelung zur lösbaren Verbindung des Gehäuseoberteils 4 mit dem Gehäuseunterteil 5 dargestellt. Das Gehäuseoberteil 4 weist auf der einen Seite einen federnden Rastarm 9 auf, welcher mit einem Rasthaken 10 des Gehäuseunterteils 5 zusammenwirkt. Auf der anderen Seite des Gehäuseoberteils 4 ist eine Lagerschale 11 ausgebildet, in die ein Lagerkopf 12 eingreift. Somit kann das Gehäuseoberteil 4 nach Lösen der aus dem Rastarm 9 und dem Rasthaken 10 bestehenden Verriegelung entweder um den Lagerkopf 12 geschwenkt oder auch ganz von dem Gehäuseunterteil 5 gelöst werden. Der Rastarm 9 weist an seinem oberen Ende einen gerippten Griffabschnitt 13 auf, um das Betätigen des federnden Rastarmes 9 mittels eines Fingers zu erleichtern.

Das Gehäuseunterteil 5 weist zwei sich gegenüberliegende Rastarme 14 und 15 auf, an denen jeweils ebenfalls ein Griffabschnitt 13 ausgebildet ist. Über die beiden federnden Rastarme 14 bzw. 15 kann jeweils ein sich an der Unterseite 16 des Gehäuseunterteils 5 befindender Rasthaken 17 bzw. 18 so betätigt werden, daß das Gehäuseunterteil 5 von der Tragschiene 2 abnehmbar ist. Die Rastarme 14, 15 wirken nach Art einer Wippe mit den entsprechenden Rasthaken 17, 18 zusammen und sind mit diesen jeweils einteilig verbunden.

Fig. 1 - besonders in den Detailvergrößerungen I und II - zeigt, daß der Rastarm 14 des Gehäuseunterteils 5 gleichzeitig die Funktion des Rasthakens 10 für den Rastarm 9 des Gehäuseoberteils 4 übernimmt. Hierzu ist das Ende des Rastarmes 14 als Rasthaken 10 ausgebildet. Außerdem dient der Rastarm 15 des Gehäuseunterteils 5 gleichzeitig als Lagerkopf 12 für die an dem Gehäuseoberteil 4 ausgebildete Lagerschale 11. Durch einfache Ausbildung der Enden der Rastarme 14, 15 kann somit sowohl ein zusätzlicher Rasthaken als auch ein zusätzlicher Lagerkopf vermieden werden, was die Herstellung des Gehäuseunterteils 5 zum einen vereinfacht, zum anderen eine schmale Ausführung des Gehäuseunterteil 5 ermöglicht.

Das Lösen des elektronischen Gerätes 1 von der Tragschiene 2 erfolgt nun, wie in den Fig. 1 a bis 1 c dargestellt, wie folgt:
a) Das elektronische Gerät 1 mit dem Gehäuseoberteil 4 und dem Gehäuseunterteil 5 befindet sich zunächst auf der Tragschiene 2, wobei das Gehäuseunterteil 5 mit den Rasthaken 17, 18 auf der Tragschiene 2 aufgerastet ist und das Gehäuseoberteil 4 auf dem Gehäuseunterteil 5 befestigt ist.
b) Durch Drücken mit einem Finger auf den Griffabschnitt 13 des Rastarmes 9 wird die Verbindung zwischen Rastarm 9 und Rasthaken 10 gelöst. Nun kann das Gehäuseoberteil 4 um den Lagerkopf 12 geschwenkt und dann ganz von dem Gehäuseunterteil 5 abgehoben werden.
c) Um das Gehäuseunterteil 5 von der Tragschiene 2 zu lösen, wird gleichzeitig auf die beiden Griffabschnitte 13 an den Rastarmen 14 und 15 gedrückt, so daß die Verrastung zwischen den Rasthaken 17 bzw. 18 und der Tragschiene 2 gelöst wird. Dieses Lösen des Gehäuseunterteils 5 kann auf einfache Weise mit einer einzigen Hand geschehen.

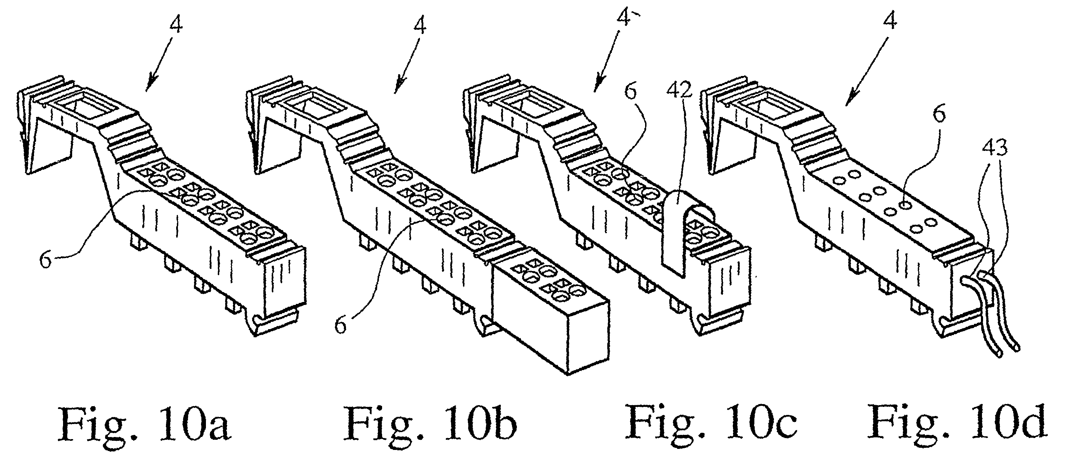

Fig. 2 zeigt eine Mehrzahl von benachbart auf einer Tragschiene 2 aufgerasteten elektronischen Geräten 1. Bei einem dieser elektronischen Geräte 1 ist zum einen das Gehäuseoberteil 4 von dem Gehäuseunterteil 5 und zum anderen das Gehäuseunterteil 5 von der Tragschiene 2 gelöst. Das Gehäuseunterteil 5 dieses elektronischen Gerätes 1 ist im Vergleich zu den benachbarten elektronischen Geräten 1 herausgezogen. Hier wird deutlich, daß jedes beliebige elektronische Gerät 1, unabhängig von seiner Position bezogen auf die anderen elektronischen Geräte 1, von der Tragschiene 2 gelöst werden kann, um beispielsweise ein Gehäuseunterteil 5 mit einer defekten Elektronik auszutauschen. Fig. 2 zeigt auch, daß es eine Vielzahl von unterschiedlichen Gehäuseoberteilen 4 gibt, die sich beispielsweise in der Art und Anzahl der Anschlüsse 6 unterscheiden (vgl. auch Fig. 10).

Die einzelnen elektronischen Geräte 1 sind über selbstaufbauende Stromschienen 8 miteinander verbunden. Das Prinzip einer solchen selbstaufbauenden Stromschiene 8 ist in Fig. 3 dargestellt. Die Stromschiene 8 besteht zum einen aus einem Messerkontakt 19, zum anderen aus einer sich in entgegengesetzter Richtung zum Messerkontakt 19 erstreckenden, doppelschenkligen Kontaktaufnahme 20. Solche Stromschienen 8 befinden sich in größerer Anzahl im Gehäuseunterteil 5, wobei die Messerkontakte 19 zur einen Seite 21 des Gehäuseunterteils 5 und die doppelschenkligen Kontaktaufnahmen 20 zur anderen Seite 22 des Gehäuseunterteils 5 hinausragen.

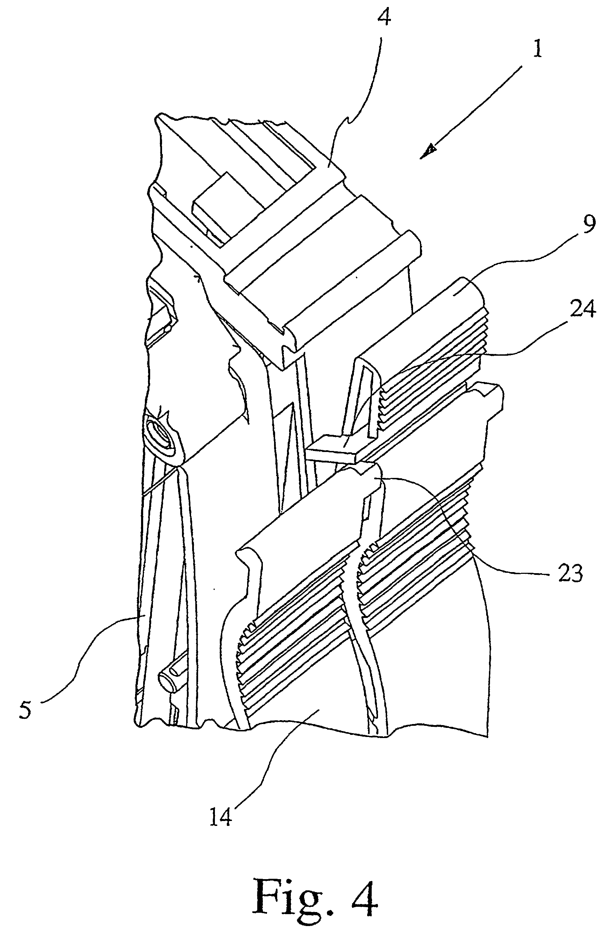

Anhand des Detailausschnittes zweier benachbarter elektronischer Geräte 1, wie er in Fig. 4 dargestellt ist, wird eine besonders vorteilhafte Ausgestaltung der Erfindung deutlich, daß nämlich beim Lösen des Gehäuseunterteils 5 des n-ten elektronischen Gerätes 1 das Gehäuseoberteil 4 des (n+1)-ten Gerätes 1 automatisch gelöst wird. Hierzu weist der Rastarm 14 des Gehäuseunterteils 5 einen seitlichen Vorsprung 23 und der Rastarm 9 des Gehäuseoberteils 4 ebenfalls einen seitlichen Vorsprung 24 auf. Bezogen auf ein elektronisches Gerät 1 erstreckt sich der Vorsprung 23 am Rastarm 14 in die entgegengesetzte Richtung wie der Vorsprung 24 des Rastarmes 9. Dadurch ist gewährleistet, daß der Vorsprung 23 des n-ten Gerätes 1 und der Vorsprung 24 des (n+1)-ten Gerätes aufeinander zuweisen. Die Vorsprünge 23 bzw. 24 zweier benachbarter Geräte 1 wirken nun so zusammen, daß beim Betätigen des Rastarms 14 des n-ten Gerätes 1 der Vorsprung 23 des n-ten Gerätes 1 gegen den Vorsprung 24 am Rastarm 9 des (n+1)-ten Gerätes 1 drückt. Somit wird durch Drücken des Rastarmes 14 des n-ten Gerätes 1 automatisch auch der Rastarm 9 des (n+1)-ten Gerätes 1 betätigt und das Gehäuseoberteil 4 des (n+1)-ten Gerätes 1 wird von seinem Gehäuseunterteil 5 gelöst. Durch diese Maßnahme wird das Gehäuseoberteil 4 des (n+1)-ten Gerätes 1 vor einer Beschädigung durch die Messerkontakte 19, welche an der einen Seite 21 des n-ten Gehäuseunterteils 5 herausragen, geschützt.

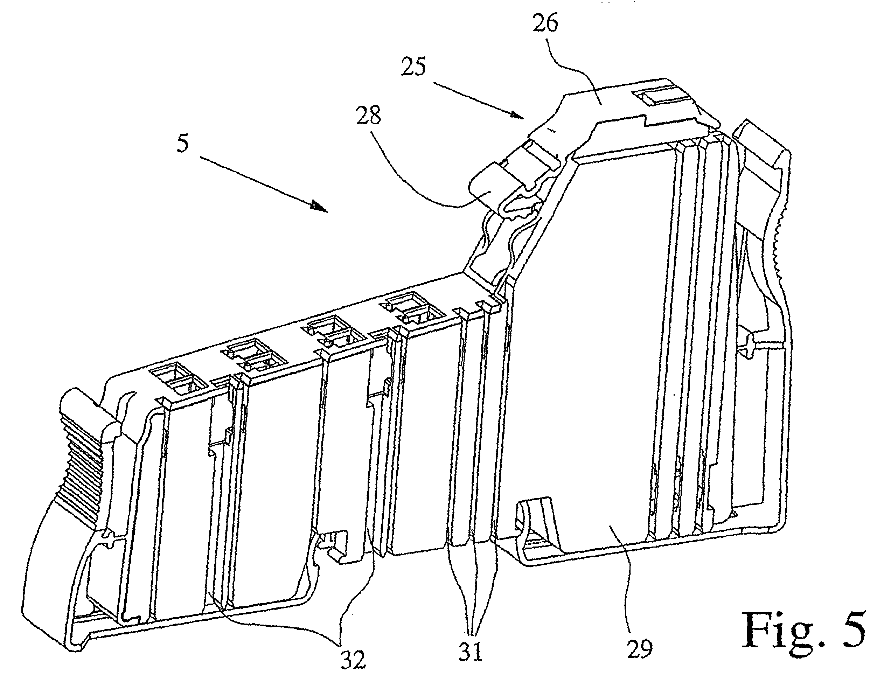

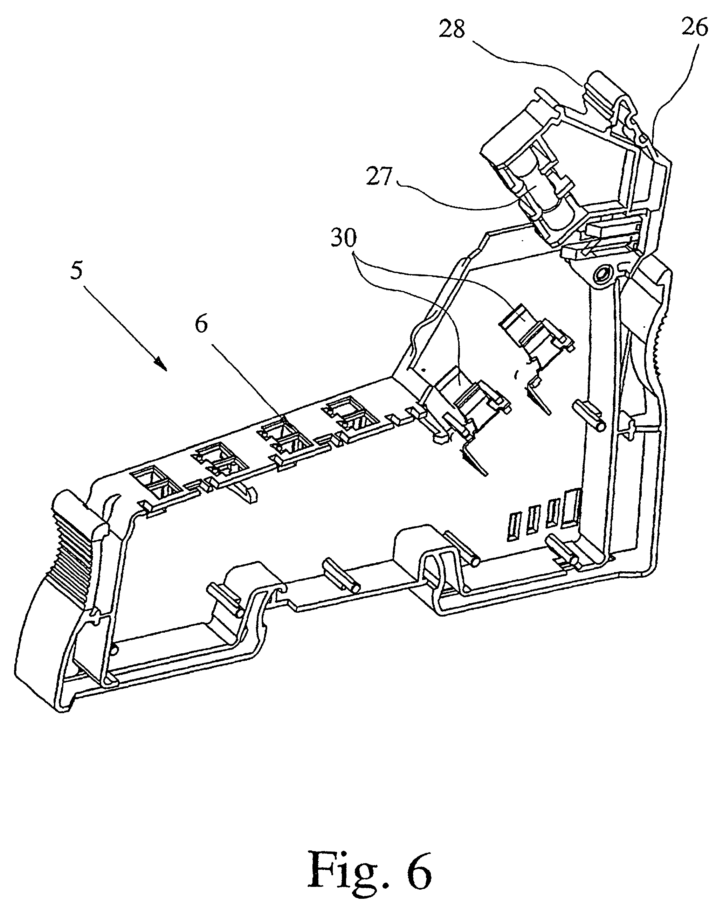

Die Fig. 5 und 6 zeigen eine Ausführung eines Gehäuseunterteils 5, bei dem am oberen Rand 25 des Gehäuseunterteils 5 ein zusätzliches Gehäuseelement 26, welches zur Aufnahme einer Sicherung 27 dient, schwenkbar angelenkt ist. Fig. 5 zeigt dabei die Betriebsstellung des Gehäuseunterteils 5, in der die Sicherung 27 in ihrer Position im Inneren des Gehäuseunterteils 5 anliegt, Fig. 6 zeigt die Position, in der die Sicherung 27 ausgetauscht werden kann. Hierzu wird das Gehäuseelement 26 mit der Sicherung 27 mit Hilfe eines Griffelements 28 aus dem Gehäuseunterteil 5 herausgeschwenkt. In Fig. 6 sind - dadurch, daß eine Seitenwand 29 des Gehäuseunterteils 5 weggelassen wurde - die sich im Inneren des Gehäuseunterteils 5 befindenden elektrischen Kontakte 30 für die Sicherung 27 dargestellt. Der Einfachheit halber ist die sonstige Elektronik, die sich ebenfalls im Inneren des Gehäuseunterteils 5 befindet, hier nicht dargestellt.

In Fig. 5 sind in der Seitenwand 29 mehrere Schlitze 31 sichtbar, in denen die doppelschenkligen Kontaktaufnahmen 20 zur Aufnahme der Messerkontakte 19 eines benachbarten elektronischen Geräts 1 angeordnet sind. Darüber hinaus befindet sich in der Seitenwand 29 eine zweite Art von Schlitzen 32, mit denen Befestigungshaken 33 eines benachbarten elektronischen Gerätes 1 in Eingriff gebracht werden können. Sowie die Messerkontakte 19 zusammen mit den doppelschenkligen Kontaktaufnahmen 20 für eine sichere elektrische Verbindung benachbarter elektronischer Geräte 1 sorgen, gewährleisten die Befestigungshaken 33 zusammen mit den Schlitzen 32 einen ebenso sicheren mechanischen Kontakt zwischen benachbarten elektronischen Geräten 1.

Fig. 7 zeigt eine Ausführungsform eines Gehäuseunterteils 5 und eines von diesem gelösten Gehäuseoberteils 4, wobei auch hier - wie in Fig. 6 - die eine Seitenwand 29 des Gehäuseunterteils 5 weggelassen wurde. Es sind die Steckerkontakte 7, welche sich jeweils aus einer Steckerbuchse 34 und einem dazugehörigen Stecker 35 zusammensetzen, deutlich zu erkennen. Die Steckerbuchsen 34 befinden sich an der Oberseite 36 des Gehäuseunterteils 5 und sind mit der - auch hier nicht dargestellten - Elektronik verbunden. Demgegenüber befinden sich die Stecker 35 an der Unterseite 37 des Gehäuseoberteils 4. Die Stecker 35 sind an ihrer dem Gehäuseunterteil 5 abgewandten Seite mit den Anschlüssen 6 verbunden. Diese Anschlüsse 6 dienen zur Kontaktierung elektrischer Leitungen, wie sie beispielsweise von Sensoren oder Aktoren an das elektronische Gerät 1 herangeführt werden, mit dem Gehäuseoberteil 4 und können beispielsweise als Federkraft- oder Schraubklemmen ausgeführt sein.

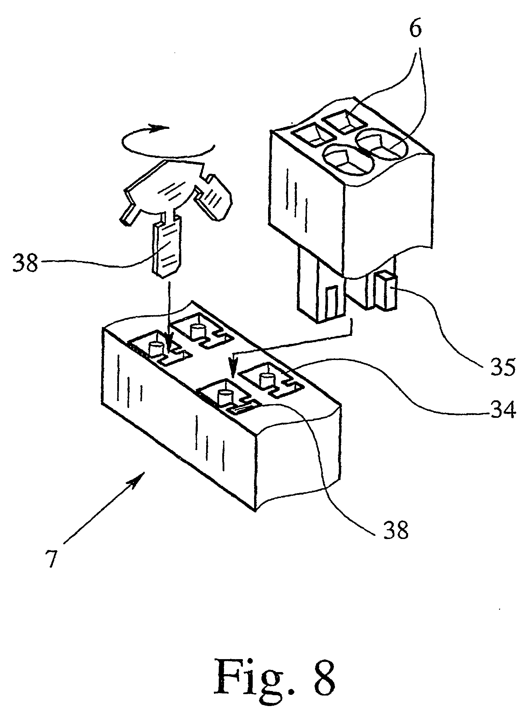

In Fig. 8 ist das Prinzip einer möglichen Codierung der Steckerkontakte 7 dargestellt. Die Codierung kann auf einfache Weise beispielsweise dadurch realisiert werden, daß Stifte 38 in Teilbereiche der Steckerbuchsen 34 eingesteckt werden. Dadurch kann die für die Stecker 35 zugängliche Form der Steckerbuchsen 34 verändert werden, so daß nur Stecker 35 mit einer entsprechenden Form in die Steckerbuchsen 34 eingeführt werden können. Eine fehlerhafte Kontaktierung wird somit auf einfache Weise verhindert. Dies ist dann sehr hilfreich, wenn beispielsweise zu Reparaturzwecken mehrere Gehäuseoberteile 4 von nebeneinander angeordneten elektronischen Geräten 1 gleichzeitig abgenommen werden und es beim anschließenden Wiederaufsetzen der Gehäuseoberteile 4 auf die Gehäuseunterteile 5 ansonsten zu einem Vertauschen der Gehäuseoberteile 4 kommen könnte.

In Fig. 9 ist eine weitere Ausführungsform eines elektronischen Gerätes 1 dargestellt, bei dem eine Mehrzahl von Feldern 39, 40 zur Beschriftung und Signalkennzeichnung auf dem Gehäuseoberteil 4 und dem Gehäuseunterteil 5 aufgebracht werden können. Zum einen gibt es die Möglichkeit, daß Felder 39 auf dafür vorgesehene Schienen 41 am Gehäuseoberteil 4 und am Gehäuseunterteil 5 aufgeschoben werden, zum anderen können aber auch großflächigere Felder 40 schwenkbar am Gehäuseoberteil 4 befestigt werden. Diese Felder 40 können dann als zusätzliche Sicherung vor ungewollter Berührung zur Abdeckung der Anschlüsse 6 dienen. Auch können die unterschiedlichen Anschlüsse 6 farblich gekennzeichnet oder beschrift werden, so daß beispielsweise eine deutliche Unterscheidung zwischen einem Masseanschluß und einem Signalanschluß erreicht wird. In Fig. 9 sind sowohl die Befestigungshaken 33 als auch die Messerkontakte 19 zu erkennen, die auf der Seite 21 aus dem Gehäuseunterteil 5 herausragen.

Der Teil des Gehäuseoberteils 4, welcher das die Sicherung 27 aufnehmende Gehäuseelement 26 abdeckt, kann durchsichtig ausgeführt sein, um eine schnelle und einfache Überprüfung der Sicherung 27 zu gewährleisten. Anstelle einer Sicherung 27 können sich unter einem solchen durchsichtigen Abschnitt des Gehäuseoberteils 4 auch Leuchtdioden zur Signal- oder Zustandsanzeige des jeweiligen elektronischen Gerätes 1 befinden.

In Fig. 10 sind insgesamt vier unterschiedliche Varianten von Gehäuseoberteilen 4 dargestellt. Die Ausführungsformen gemäß den Fig. 10 a und Fig. 10 b unterscheiden sich dabei in der Anzahl der zur Verfügung stehenden Anschlüsse 6. Das Gehäuseoberteil 4 aus Fig. 10 a ist zum Anschluß von zwei 4-Leiter-Kabeln geeignet, das Gehäuseoberteil 4 aus Fig. 10 b zum Anschluß von vier 3-Leiter-Kabeln. Fig. 10 c zeigt eine Ausführungsform mit einer metallischen Abschirmung 42 und Fig. 10 d ein vorkonfektioniertes Gehäuseoberteil 4 mit zwei Kabeln 43. Selbstverständlich sind weitere Varianten möglich, insbesondere zum Anschluß von 1, 2, 3 und 4-Leiter-Kabeln. Alle Gehäuseoberteile 4 haben die gleiche Breite und können alternativ auf dasselbe Gehäuseunterteil 5 aufgesetzt werden. Diese vielfälltigen Möglichkeiten verdeutlichen nochmals die hochmodulare Verwendungsweise des erfindungsgemäßen elektronischen Geräts 1.

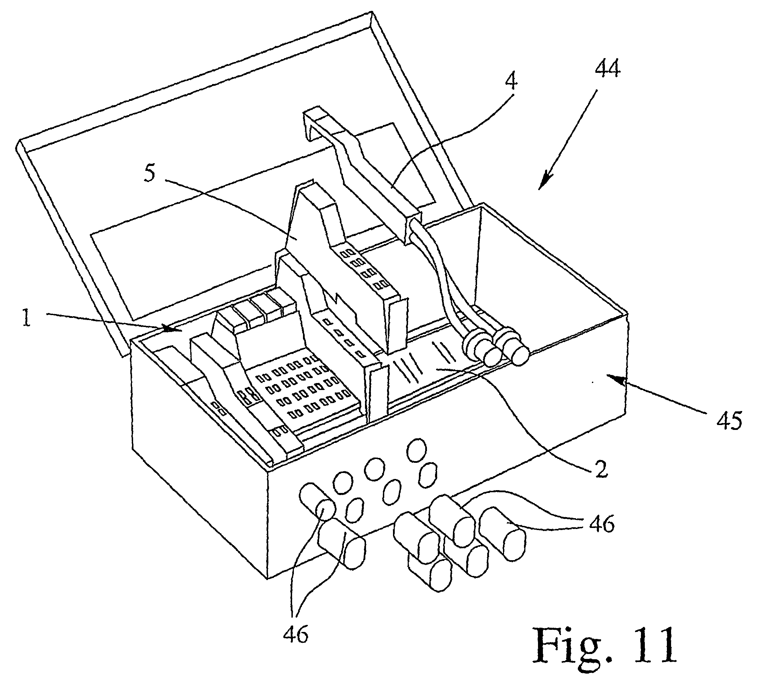

Abschließend zeigt Fig. 11 eine genormte Ein-/Ausgabebox 44, die mindestens der Schutzklasse IP *65* genügt und im Inneren eine Tragschiene 2 aufweist, auf die die für den speziellen Anwendungsfall benötigten elektronischen Geräte 1 aufgerastet werden können. An der Vorderseite 45 der Ein-/Ausgabebox 44 sind Kabeldurchführungen 46 vorgesehen, so daß die Konfektionierung und der Aufbau der fertigen, d. h. mit elektronischen Geräte 1 bestückten Ein-/Ausgabebox 44 vollkommen werkzeuglos und damit schnell und einfach erfolgen kann. Darüber hinaus kann durch die Modultechnik der elektronischen Geräte 1 eine Ein-/Ausgabebox 44 beliebig bestückt werden und somit dem jeweiligen Anforderungen entsprechend optimal angepaßt werden. Bei einer ausreichenden Größe der Ein-/Ausgabebox 44 ist die spätere Ergänzung mit weiteren elektronischen Geräten 1 problemlos möglich.

## Patentansprüche

1. Elektronisches Gerät zum Aufsetzen auf eine Tragschiene (2), mit einem Gehäuse (3), wobei das Gehäuse (3) aus einem mit der Tragschiene (2) lösbar verbindbaren Gehäuseunterteil (5) und aus einem mit dem Gehäuseunterteil (5) lösbar verbindbaren Gehäuseoberteil (4) besteht, das Gehäuseunterteil (5) zum einen eine Elektronik enthält und zum anderen die Verbindung zu einem Bus-System herstellt und das Gehäuseoberteil (4) über Steckerkontakte (7) mit dem Gehäuseunterteil (5) elektrisch verbunden ist, **dadurch gekennzeichnet, daß** das Gehäuseoberteil (4) Anschlüsse (6) für elektrische Leitungen aufweist, die Anschlüsse (6) über die Steckerkontakte (7) mit dem Gehäuseunterteil (5) verbunden sind, das Gehäuseoberteil (4) über eine rastbare Verriegelung mit dem Gehäuseunterteil (5) verbindbar ist, wobei die Verriegelung wenigstens einen federnden Rastarm (9) und einen zum Rastarm (9) korrespondierenden Rasthaken (10) aufweist und der Rastarm (9) am Gehäuseoberteil (4) und der Rasthaken (10) am Gehäuseunterteil (5) vorgesehen sind.

2. Elektronisches Gerät nach Anspruch 1, **dadurch gekennzeichnet, daß** mehrere Geräte (1) benachbart zueinander auf der Tragschiene (2) aufrastbar und über selbstaufbauende Stromschienen (8) miteinander kontaktierbar sind.

3. Elektronisches Gerät nach Anspruch 1 oder 2, **dadurch gekennzeichnet, daß** das Gehäuseoberteil (4) auf das Gehäuseunterteil (5) aufschwenkbar ist und die Verriegelung einen von der Außenseite des Gehäuses (3) manuell betätigbaren Griffabschnitt (13) am Rastarm (9) zum Lösen des Gehäuseoberteils (4) vom Gehäuseunterteil (5) aufweist.

4. Elektronisches Gerät nach einem der Ansprüche 1 bis 3, **dadurch gekennzeichnet, daß** das Gehäuseunterteil (5) zwei federnde Rastarme (14, 15) aufweist, daß über die Rastarme (14, 15) die an der Unterseite (16) des Gehäuseunterteils (5) angeordnete Rasthaken (17, 18) betätigbar sind und daß die Rasthaken (17, 18) mit der Tragschiene (2) derart zusammenwirken, daß das Gehäuseunterteil (5) durch die Rasthaken (17, 18) auf der Tragschiene (2) lösbar befestigt ist.

5. Elektronisches Gerät nach Anspruch 4, **dadurch gekennzeichnet, daß** ein Rastarm (14) des Gehäuseunterteils (5) gleichzeitig die Funktion des Rasthakens (10) für den korrespondierenden Rastarm (9) des Gehäuseoberteils (4) übernimmt.

6. Elektronisches Gerät nach einem der Ansprüche 1 bis 5, **dadurch gekennzeichnet, daß** die selbstaufbauende Stromschiene (8) aus einem Messerkontakt (19) und einer doppelschenkligen Kontaktaufnahme (20) besteht und der Messerkontakt (19) auf der einen Seite (21) und die Kontaktaufnahme (20) auf der anderen Seite (22) des Gehäuseunterteils (5) aus diesem herausragt.

7. Elektronisches Gerät nach einem der Ansprüche 1 bis 6, **dadurch gekennzeichnet, daß** beim Lösen des Gehäuseunterteils (5) des n-ten Gerätes (1) das Gehäuseoberteil (4) des (n+1)-ten Gerätes (1) automatisch zumindest einseitig gelöst wird.

8. Elektronisches Gerät nach Anspruch 7, **dadurch gekennzeichnet, daß** der Rastarm (14) des Gehäuseunterteils (5) seitlich einen Vorsprung (23) und der Rastarm (9) des Gehäuseoberteils (4) ebenfalls einen Vorsprung (24) aufweist.

9. Elektronisches Gerät nach Anspruch 8, **dadurch gekennzeichnet, daß** beim Lösen des Gehäuseunterteils (5) des n-ten Gerätes (1) der Vorsprung (23) des Rastarms (14) des Gehäuseunterteils (5) des n-ten Gerätes (1) unter den korrespondierenden Vorsprung (24) des Rastarms (9) des Gehäuseoberteils (4) des (n+1)-ten Gerätes (1) eingreift und das Gehäuseoberteil (4) des (n+1)-ten Gerätes (1) somit zumindest einseitig gelöst wird.

10. Elektronisches Gerät nach einem der Ansprüche 1 bis 9, **dadurch gekennzeichnet, daß** am oberen Rand (25) des Gehäuseunterteils (5) ein zusätzliches Gehäuseelement (26) schwenkbar angelenkt ist und das Gehäuseelement (26) zur Aufnahme einer Sicherung (27) dient.

11. Elektronisches Gerät nach Anspruch 10, **dadurch gekennzeichnet, daß** das Gehäuseelement (26) durch das Gehäuseoberteil (4) einerseits abgedeckt ist, andererseits bei gelöstem Gehäuseoberteil (4) zumindest die in dem Gehäuseelement (26) aufgenommene Sicherung (27) entfernt werden kann.

12. Elektronisches Gerät nach Anspruch 11, **dadurch gekennzeichnet, daß** das Gehäuseoberteil (4) an der Stelle, an der es das Gehäuseelement (26) mit der Sicherung (27) abdeckt, durchsichtig ist.

13. Elektronisches Gerät nach einem der Ansprüche 1 bis 12, **dadurch gekennzeichnet, daß** die Steckerkontakte (7), welche aus Steckerbuchsen (34) und Steckern (35) bestehen, über eine Steckerkodierung gesichert werden können.

14. Elektronisches Gerät nach Anspruch 13, **dadurch gekennzeichnet, daß** zur Stekkerkodierung in die Steckerbuchse (34) des Gehäuseunterteils (5) Stifte (38) einsteckbar sind, so daß nur ein "richtiges" Gehäuseoberteil (4) mit seinen Steckern (35) in die Steckerbuchse (34) paßt.

15. Elektronisches Gerät nach einem der Ansprüche 1 bis 14, **dadurch gekennzeichnet, daß** sowohl das Gehäuseoberteil (4) als auch das Gehäuseunterteil (5) mit nur einer Hand gelöst werden können.

16. Elektronisches Gerät nach einem der Ansprüche 1 bis 15, **dadurch gekennzeichnet, daß** die Anschlüsse (6) für die elektrische Leitungen am Gehäuseoberteil (4) durch Federkraftklemmen oder Schraubklemmen realisiert sind.

17. Elektronisches Gerät nach einem der Ansprüche 1 bis 16, **dadurch gekennzeichnet, daß** das Gehäuseoberteil (4) und/oder das Gehäuseunterteil (5) Felder (39, 40) aufweist, die zur Beschriftung und Signalkennzeichnung dienen.

## Claims

1. An electronic device for placement on a mounting rail (2), with a casing (3), wherein the casing (3) consists of a lower casing section (5) that can be detachably connected with the mounting rail (2), and an upper casing part (4) that can be detachably connected with the lower casing section (5), the lower casing section (5) contains electronic components and establishes the connection to a bus system, and the upper casing section (4) is electrically connected with the lower casing section (5) via plug contacts (7), **characterized in that** the upper casing section (4) has terminals (6) for electrical lines, the terminals (6) are connected with the lower casing section (5) via the plug contacts (7), the upper casing section (4) can be connected with the lower casing section (5) via a latching interlock, wherein the interlock has at least one spring-loaded latching arm (9) and a latching hook (10) corresponding to the latching arm (9), and the latching arm (9) is provided on the upper casing section (4), while the latching hook (10) is provided on the lower casing section (5).

2. The electronic device according to claim 1, **characterized in that** several devices (1) can be latched one next to the other on the mounting rail (2) and contacted with each other via self-assembling current rails (8).

3. The electronic device according to claim 1 or 2, **characterized in that** the upper casing section (4) can be swiveled open on the lower casing section (5), and the interlock has a gripping section (13) on the latching arm (9) that can be manually actuated from the outside of the casing (3) for detaching the upper casing section (4) from the lower casing section (5).

4. The electronic device according to one of claims 1 to 3, **characterized in that** the lower casing section (5) has two spring-loaded latching arms (14, 15), that the latching hooks (17, 18) arranged on the bottom (16) of the lower casing section (5) can be activated via the latching arms (14, 15), and that the latching hooks (17, 18) interact with the mounting rail (2) in such a way that the lower casing section (5) is detachably secured to the mounting rail (2) via the latching hooks (17, 18).

5. The electronic device according to claim 4, **characterized in that** a latching arm (14) of the lower casing section (5) simultaneously acts as the latching hook (10) for the corresponding latching arm (9) of the upper casing section (4).

6. The electronic device according to one of claims 1 to 5, **characterized in that** the self-assembling current rail (8) consists of a blade contact (19) and a double-arm contact locator (20), and the blade contact (19) projects on the one side (21), while the contact locator (20) projects on the other side (22) of the lower casing section (5).

7. The electronic device according to one of claims 1 to 6, **characterized in that** the upper casing section (4) of the (n+1)-th device (1) is detached automatically on at least one side while detaching the lower casing section (5) of the n-th device (1).

8. The electronic device according to claim 7, **characterized in that** the latching arm (14) of the lower casing section (5) has a sideways projection (23), and the latching arm (9) of the upper casing section (4) also has a projection (24).

9. The electronic device according to claim 8, **characterized in that** the projection (23) of the latching arm (14) of the lower casing section (5) of the n-th device (1) extends under the corresponding projection (24) of the latching arm (9) of the upper casing section (4) of the (n+1)-th device (1) while detaching the lower casing section (5) of the n-th device (1), thereby detaching the upper casing section (4) of the (n+1)-th device (1) on at least one side.

10. The electronic device according to one of claims 1 to 9, **characterized in that** an additional casing element (26) is pivoted to the upper edge (25) of the lower casing section (5), and the casing element (26) is used for accommodating a safety device (27).

11. The electronic device according to claim 10, **characterized in that** the casing element (26) is covered by the upper casing section (4), while at least the safety device (27) accommodated in the casing element (26) can be removed with the upper casing section (4) detached.

12. The electronic device according to claim 11, **characterized in that** the upper casing section (4) is translucent where it covers the casing element (26) with the safety device (27).

13. The electronic device according to one of claims 1 to 12, **characterized in that** the plug contacts (7) consisting of sockets (34) and plugs (35) can be secured via a plug coding.

14. The electronic device according to claim 13, **characterized in that** pins (38) can be inserted into the socket (34) of the lower casing section (5) for coding the plug, so that only a "correct" upper casing section (4) fits into the socket (34) with its plugs (35).

15. The electronic device according to one of claims 1 to 14, **characterized in that** both the upper casing part (4) and lower casing part (5) can be detached with just one hand.

16. The electronic device according to one of claims 1 to 15, **characterized in that** the terminals (6) for the electrical lines on the upper casing section (4) are realized with spring-energy or screw-type clamps.

17. The electronic device according to one of claims 1 to 16, **characterized in that** the upper casing section (4) and/or the lower casing section (5) has fields (39, 40) used for labeling and signal designation.

## Revendications

1. Appareil électronique à poser sur un rail porteur (2), comportant un boîtier (3), le boîtier (3) consistant en une partie inférieure de boîtier (5) pouvant être reliée avec le rail support (2) de manière amovible et en une partie supérieure de boîtier (4) pouvant être reliée avec la partie inférieure du boîtier (5) de manière amovible, la partie inférieure du boîtier (5) contenant d'une part un système électronique et établissant d'autre part la liaison avec un système de bus et la partie supérieure du boîtier (4) étant reliée au niveau électrique par des contacts de branchement (7) avec la partie inférieure du boîtier (5), **caractérisé en ce que** la partie supérieure du boîtier (4) présente des raccordements (6) pour des câbles électriques, les raccordements (6) étant. reliés par l'intermédiaire des contacts de branchement (7) avec la partie inférieure du boîtier (5), la partie supérieure du boîtier (4) pouvant être reliée par l'intermédiaire d'un verrouillage encliquetable avec la partie inférieure du boîtier (5), le verrouillage présentant au moins un bras d'encliquetage élastique (9) et un crochet d'encliquetage (10) correspondant au bras d'encliquetage (9) et le bras d'encliquetage (9) étant prévu sur la partie supérieure du boîtier (4) et le crochet d'encliquetage (10) sur la partie inférieure du boîtier (5).

2. Appareil électronique selon la revendication 1, **caractérisé en ce que** plusieurs appareils (1) peuvent être encliquetés à proximité les uns des autres sur le rail support (2) et peuvent être mis en contact les uns avec les autres par des rails de courant auto-structurants (8).

3. Appareil électronique selon la revendication 1 ou 2, **caractérisé en ce que** la partie supérieure du boîtier (4) peut pivoter sur la partie inférieure du boîtier (5) et que le verrouillage présente une section de saisie (13) actionnable manuellement à partir du côté extérieur du boîtier (3) sur le bras d'encliquetage (9) pour détacher la partie supérieure du boîtier (4) de la partie inférieure du boîtier (5).

4. Appareil électronique selon une des revendications 1 à 3, **caractérisé en ce que** la partie inférieure du boîtier (5) présente deux bras d'encliquetage élastiques (14, 15), que les crochets d'encliquetage (17, 18) disposés sur le côté inférieur (16) de la partie inférieure du boîtier (5) sont actionnables par l'intermédiaire des bras d'encliquetage (14, 15) et que les crochets d'encliquetage (17, 18) coopèrent avec le rail support (2) de manière à ce que la partie inférieure du boîtier (5) soit fixée de manière amovible sur le rail support (2) par l'intermédiaire des crochets d'encliquetage (17, 18).

5. Appareil électronique selon la revendication 4, **caractérisé en ce qu'**un bras d'encliquetage (14) de la partie inférieure du boîtier (5) assure simultanément la fonction du crochet d'encliquetage (10) pour le bras d'encliquetage correspondant (9) de la partie supérieure du boîtier (4).

6. Appareil électronique selon une des revendications 1 à 5, **caractérisé en ce que** le rail de courant auto-structurant (8) consiste en un contact à lame (19) et un récepteur de contact à double branche (20) et que le contact à lame (19) dépasse sur un côté (21) et le récepteur de contact (20) sur l'autre côté (22) de la partie inférieure du boîtier (5) hors de celui-ci.

7. Appareil électronique selon une des revendications 1 à 6, **caractérisé en ce que**, lors du détachement de la partie inférieure du boîtier (5) de l'énième appareil (1), la partie supérieure du boîtier (4) de l'énième+1 appareil (1) est automatiquement détachée du moins d'un côté.

8. Appareil électronique selon la revendication 7, **caractérisé en ce que** le bras d'encliquetage (4) de la partie inférieure du boîtier (5) présente latéralement une saillie (23) et que le bras d'encliquetage (9) de la partie supérieure du boîtier (4) présente également une saillie (24).

9. Appareil électronique selon la revendication 8, **caractérisé en ce que**, lors du détachement de la partie inférieure du boîtier (5) de l'énième appareil (1), la saillie (23) du bras d'encliquetage (14) de la partie inférieure du boîtier (5) de l'énième appareil (1) s'engrène sous la saillie correspondante (24) du bras d'encliquetage (9) de la partie supérieure du boîtier (4) de l'énième+1 appareil (1) et que la partie supérieure du boîtier (4) de l'énième+1 appareil (1) est ainsi détachée du moins d'un côté.

10. Appareil électronique selon une des revendications 1 à 9, **caractérisé en ce que**, sur le bord supérieur (25) de la partie inférieure du boîtier (5), un élément supplémentaire de boîtier (26) est articulé en rotation et que l'élément du boîtier (26) sert à recevoir une sécurité (27).

11. Appareil électronique selon la revendication 10, **caractérisé en ce que** l'élément de boîtier (26) est d'une part recouvert par la partie supérieure du boîtier (4), que, d'autre part, lorsque la partie supérieure du boîtier (4) est détachée, au moins la sécurité (27) intégrée dans l'élément de boîtier (26) peut être enlevée.

12. Appareil électronique selon la revendication 11, **caractérisé en ce que** la partie supérieure du boîtier (4) est transparente à l'endroit où elle recouvre l'élément de boîtier (26) avec la sécurité (27).

13. Appareil électronique selon une des revendications 1 à 12, **caractérisé en ce que** les contacts de branchement (7), lesquels consistent en broches femelles (34) et en broches mâles (35), peuvent être bloqués grâce à un codage de branchement.

14. Appareil électronique selon la revendication 13, **caractérisé en ce que** des fiches (38) peuvent être insérées dans la broche femelle (34) de la partie inférieure du boîtier (5) aux fins d'un codage de branchement, de sorte que seule une « bonne » partie supérieure de boîtier (4) s'adapte avec ses broches mâles (35) dans la broche femelle (34).

15. Appareil électronique selon une des revendications 1 à 14, **caractérisé en ce qu'**aussi bien la partie supérieure du boîtier (4) que la partie inférieure du boîtier (5) peuvent être détachées d'une seule main.

16. Appareil électronique selon une des revendications 1 à 15, **caractérisé en ce que** les raccordements (6) pour les câbles électriques sur la partie supérieure du boîtier (4) sont réalisés par des bornes à force de ressort ou des bornes à vis.

17. Appareil électronique selon une des revendications 1 à 16, **caractérisé en ce que** la partie supérieure du boîtier (4) et/ou la partie inférieure du boîtier (5) présente des champs (49, 40) qui servent pour des inscriptions et la signalisation.
